# EUROPEAN PATENT APPLICATION

(11) **EP 4 230 294 A1**
(43) Date of publication of application: **23.08.2023**
(21) Application number: 21880497.9
(22) Date of filing: 13.10.2021
(51) Int. Cl.: B01J 37/02, B01J 23/42, C23C 16/455, C23C 16/44, C23C 16/40

(54) **METHOD FOR PRODUCING METAL CATALYST HAVING COMPOSITE FILM DEPOSITED THEREON BY MEANS OF ALD PROCESS, AND METAL CATALYST ACCORDING THERETO**

(30) Priority: 15.10.2020 KR 20200133723
(71) Applicant: Hanwha Solutions Corporation, Jung-gu Seoul 04541 (KR); Korea Advanced Institute of Science and Technology, Daejeon 34141 (KR)
(72) Inventor: CHO, Young Jin, Daejeon 34128 (KR); KIM, Do Heung, Daejeon 34128 (KR); OH, Myung Seok, Daejeon 34128 (KR); IM, Sung Gap, Daejeon 34141 (KR); JANG, Won Tae, Daejeon 34141 (KR); CHOI, Keonwoo, Daejeon 34141 (KR)
(74) Representative: Berggren Oy
(86) International application number: PCT/KR2021/014099
(87) International publication number: WO 2022/080850

(57) **Abstract**

The present disclosure relates to a method for preparing a metal catalyst deposited with a layer film by ALD process and a metal catalyst thereof. More specifically, the present disclosure is intended to inhibit sintering of catalyst particles to prevent activity decrease, thus stably maintaining high activity, and simultaneously, providing heat stability, by layer-by-layer deposition of a layer film with alternation of different inorganic films on the surface of a metal catalyst in an ALD process.

## Description

### BACKGROUND OF THE INVENTION

### (a) Field of the Invention

The present disclosure relates to a method for preparing a metal catalyst deposited with a layer film by ALD process and a metal catalyst thereof. More specifically, the present disclosure is intended to inhibit sintering of catalyst particles to prevent activity decrease, thus stably maintaining high activity, and simultaneously, providing heat stability, by layer-by-layer deposition of a layer film with alternation of different inorganic films on the surface of a metal catalyst in an ALD process.

### (b) Description of the Related Art

Atomic layer deposition (ALD) means a deposition method for growing a thin film as an atomic layer unit. In the case of common chemical deposition, precursors are simultaneously injected and a surface reaction is progressed together with a gas phase reaction, while in the case of atomic layer deposition, a gas phaser reaction is inhibited through sequential injection of reactants, and deposition is progressed by a surface reaction through self-limited adsorption on the surface to be deposited. Thus, since the thickness of overall deposited film is controlled through the number of deposition cycle, thickness control at the atom layer unit is easy. Further, due to various kinds and excellent properties such as good thin film properties, processability even at relatively low temperature, and the like, it has been mainly applied for semiconductor dielectrics, magnetic substances, and the like, and developed.

However, with recent development of nano technology, atomic layer deposition of oxide departs from the tendency of study mainly centered on traditional integrated circuit devices, and its application to various fields are being studied, and particularly, various and specific studies for its application to metal thin film coating of a catalyst are being currently actively progressed.

For example, Chinese Registered Patent No. 102935378 uses a modified molecular sieve catalyst as a catalyst in an aldehyde-NHs condensation reaction, and it is disclosed that various metal elements can be used for modification. Further, a catalyst providing anti-coking effect by coating the catalyst surface with Al₂O₃ using an ALD process, is mentioned.

Next, examining the statement in non-patent document, Phys. Chem. C 2016. 120. No.1, it relates to a technology of improving activity by depositing a TiO₂ thin film on a Au catalyst by an ALD process, and it is stated that as the interface between Au and TiO₂ increases, activity increases. Further, it is stated that up to 20 deposition cycles, the interface increases and Au catalyst activity increases, but that at higher deposition cycles, activity of Au catalyst decreases.

Finally, in non-patent document ACS Catal. 2015. 5., Al₂O₃/TiO₂ is used in combination as a carrier for a Pt catalyst. It is stated that Al₂O₃ provides heat stability and high surface area, and TiO₂ increase dispersibility through SMSI (Strong-metal-support-interaction). Further, it is stated that TiO₂ forms SMSI with Pt to increase electron density, thus facilitating desorption of propane and decreasing coking issue. However, it is mentioned that if the rate of TiO₂ exceeds 20%, adsorption of propane decreases to the contrary, and both activity and stability decrease.

As explained above, a metal catalyst coated with an inorganic film using an ALD process is variously studied and developed, and as a part of such studies, the present disclosure has been completed to provide high activity and heat stability of a catalyst than before, by layer-by-layer deposition of a layer film with alternation of different inorganic films in the ALD process.

### [Prior Art Document]

### [Patent Document]

(Patent Document 0001) Chinese Registered Patent No. 102935378 (2013.2.20)
(Patent Document 0002) (Non-patent Document 2) J. Phys. Chem. C 2016, 120, no.1, 478486
(Patent Document 0003) (Non-patent Document 3) ACS Catal. 2015, 5, 438-447 571-577

### SUMMARY OF THE INVENTION

It is an object of the invention to solve all the above-explained problems.

It is an object of the invention to provide a catalyst deposited with a layer film by layer-by-layer deposition of different inorganic films on the surface of a catalyst through an atomic layer deposition (ALD) process.

It is an object of the invention to provide excellent sintering prevention effect, thus preparing a catalyst that exhibits high activity and simultaneously maintains high activity.

It is an object of the invention to secure a preparation process that simultaneously provides high catalyst activity and heat stability.

In order to achieve the object of the invention as described above, and realize characteristic effects of the invention as described later, characteristic constructions of the present disclosure are as follows.

According to one embodiment of the invention, there is provided a method for preparing a metal catalyst deposited with a layer film by ALD process, comprising steps of: (a) injecting a first precursor in a supported catalyst to deposit on the catalyst surface, and then, purging; (b) injecting an oxidant to react with the first precursor deposited on the catalyst surface to form an inorganic film, and then, purging; (c) injecting a second precursor to deposit the second precursor on the inorganic film, and then, purging; and (d) injecting an oxidant to form layer film, and then, purging.

According to one embodiment of the invention, there is provided a metal catalyst deposited with a layer film, prepared according to the above preparation method.

According to the present disclosure, compared to the existing co-injection preparation method wherein two reactants are simultaneously injected to prepare a layer film, a layer film can be more successfully formed according to a layer-by-layer preparation method.

According to the present disclosure, sintering of catalyst particles can be inhibited to prevent activity decrease, and high activity can be stably maintained.

According to the present disclosure, high activity and heat stability of a catalyst can be simultaneously provided.

### BRIEF DESCRIPTION OF THE DRAWINGS

Fig. 1 is a scheme showing the existing ALD process according to a co-injection preparation method.
Fig. 2 is a scheme showing the ALD process according to a layer-by-layer preparation method according to the present disclosure.
Fig. 3 is the analysis result of X-ray photoelectron spectroscopy of the catalyst according to Example 1 of the present disclosure.
Fig. 4 is the result of X-ray photoelectron spectroscopy of the catalyst according to Example 2 of the present disclosure.
Fig. 5 is the result of X-ray photoelectron spectroscopy of the catalyst according to Comparative Example.
Fig. 6 is the result showing activities of the catalysts according to Examples 1 to 2 and Comparative Example.
Fig. 7 is the result showing heat stabilities of the catalysts according to Examples 1 to 2 and Comparative Example.

### DETAILED DESCRIPTION OF THE EMBODIMENTS

Detailed description of the invention below refers to specific embodiments in which the invention can be practiced as illustrations. These embodiments are explained in detail such that a person having ordinary skill in the art can practice the invention. It is to be understood that although various embodiments of the invention are different from each other, they are not necessarily exclusive with each other. For example, specific shapes, structures and properties described herein with regard to one embodiment can be realized as other embodiments without departing from the spirit and scope of the invention. Further, it is to be understood that the position or disposition of each constructional element in each embodiment disclosed can be modified without departing from the spirit and scope of the invention. Thus, detailed description below is not intended to be limitative, but the scope of the invention, if appropriately described, is limited only by the claims attached as well as all the scopes equivalent to the claims.

Hereinafter, in order to enable a person having ordinary knowledge in the technical field to which the invention pertains can easily practice the invention, preferable embodiments of the invention will be explained in detail.

Atomic layer deposition (ALD) means a deposition method for growing a thin film on the surface of a catalyst as an atomic layer unit. Wherein, the thin film means an inorganic oxide film, and can be provided as a mono film or layer film, and in the present disclosure, it is preferably provided as a layer film.

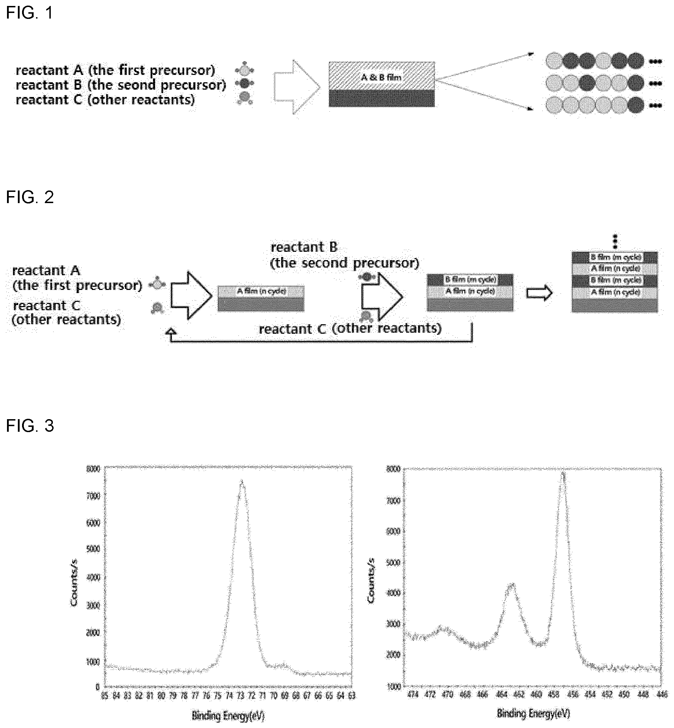

Fig. 1 is a scheme showing the existing ALD process according to a co-injection preparation method wherein reactants (precursors) are simultaneously injected, in order to deposit a layer film on the surface of a catalyst.

Fig. 2 is a scheme showing the ALD process according to layer-by-layer preparation method wherein reactants (precursors) are injected by stages, in order to deposit a layer film.

The present disclosure is intended to provide a method for preparing a catalyst deposited with a layer film according to the layer-by-layer preparation method wherein different reactants (precursors) are injected by stages as shown in Fig. 2.

According to one embodiment of the invention, there is provided a method for preparing a metal catalyst deposited with a layer film by ALD process, comprising steps of: (a) injecting a first precursor in a supported catalyst to deposit on the catalyst surface, and then, purging; (b) injecting an oxidant to react with the first precursor deposited on the catalyst surface to form an inorganic film, and then, purging; (c) injecting a second precursor to deposit the second precursor on the inorganic film, and then, purging; and (d) injecting an oxidant to form layer film, and then, purging.

That is, the inorganic film formed by the steps (a) to (b) and another inorganic film formed by the steps (c) to (d) are deposited to provide layer-by-layer composite film. Thus, compared to the existing co-injection preparation method, a layer film in which inorganic films formed by different reactants (precursors) can be clearly distinguished, can be provided.

According to one embodiment of the invention, the steps (a) to (b) are repeated 3 to 10 cycles, and then, the steps (c) to (d) are repeated 1 to 3 cycles. Wherein, 1 cycle means a series of flows of the steps (a) to (b) or steps (c) to (d).

For example, the steps (a) to (b) are repeated 3 cycles, and then, the steps (c) to (d) are progressed one cycle, thus preparing a layer film. For another example, the steps (a) to (b) are repeated 10 cycles, and then, the steps (c) to (d) are repeated 3 cycles, thus preparing a layer film. Thus, since an inorganic film of the first precursor is formed, and then, the second precursor is deposited to form another inorganic film through the ALD process according to a layer-by-layer method, a composite film in which layer film can be clearly distinguished, can be provided.

According to one embodiment of the invention, the steps (a) to (d) are repeated at least two times (dyad). In case the steps (a) to (d) are progressed one time to deposit, the thickness of the layer film provided may be 0.02 to 0. 1nm. Thus, if necessary, these steps may be progressed two times (dyad) or more to appropriately modify the thickness of the layer film freely at the level of a person having ordinary skill in the art.

According to one embodiment of the invention, the catalyst of the step (a) may be one selected from platinum (Pt), gold (Au), silver (Ag), copper (Cu), nickel (Ni), palladium (Pd), rhodium (Rh) and ruthenium (Ru), and preferably, platinum (Pt) may be used,

According to one embodiment of the invention, the carrier used for supporting in the step (a) may be at least one selected from alumina (Al₂O₃), silica (SiO₂), titania (TiO₂), zirconia (ZrO₂), zeolite and carbon, and preferably, an alumina (Al₂O₃) carrier may be used. In this case, the alumina (Al₂O₃) carrier used may be alpha-alumina (α-Al₂O₃) or gamma-alumina (y-Al₂O₃), but is not limited thereto.

Although the carbon carrier is not specifically limited, at least one selected from active carbon, carbon black, graphite, graphene, OMC (ordered mesoporous carbon) and carbon nanotube may be used.

The supporting comprises impregnation or immersion. The specific surface area of the carrier may be measured by a commonly used BET method, and the specific surface area may be 5 to 300 m²/g. Thereby, heat stability can be secured, and sufficient dispersion and catalyst activity can be provided.

According to one embodiment of the invention, the first precursor of the step (a) and the second precursor of the step (c) are different from each other, and in this case, each of the first precursor of the step (a) and the second precursor of the step (c) may be at least one selected from titanium (Ti), aluminum (Al), zinc (Zn), zirconium (Zr) and cesium (Ce).

As the first precursor, at least one precursor selected from titanium (Ti), aluminum (Al), zinc (Zn), zirconium (Zr) and cesium (Ce) may be used, and preferably, a titanium (Ti) precursor may be used. For example, the titanium precursor may be titanium tetraisopropoxide, tetrakis dimethylamido titanium, tetrakis diethylamido titanium, tetrakis dimethylamido titanium, titanium tetrachloride, titanium nitrate, titanium sulfate, and the like, but is not limited thereto.

As the second precursor, a precursor not selected as the first precursor is used, and at least one selected from titanium (Ti), aluminum (Al), zinc (Zn), zirconium (Zr) and cesium (Ce) may be used, and preferably, an aluminum (Al) precursor may be used. For example, as the alumina precursor, an organic aluminum compound may be used, and for example, trimethyl aluminum, triethyl aluminum, triisobutyl aluminum, isobutyl aluminum, dimethyl aluminum, and the like may be used, and the aluminum precursor may be in the form of a complex salt with hydride, but is not limited thereto.

According to one embodiment of the invention, the injections of the steps (a) and (c) are progressed by injecting inert gas as a carrier gas. The inert gas used may be, for example, nitrogen, helium, neon, argon, and the like, but is not limited thereto.

Further, the injections of the steps (a) and (c) are progressed respectively for 0.5 seconds to 30 seconds. Preferably, the injections are progressed respectively for 10 seconds to 20 seconds, and in this case, a time sufficient for adsorption can be provided.

According to one embodiment of the invention, as the oxidants of the step (b) and step (d), at least one selected from ultrapure purified water, alcohol, ozone, nitrous oxide and oxygen may be used, and preferably, ultrapure purified water may be used. Further, a time taken for the injection of the oxidant may be 0.5 seconds to 30 seconds.

By providing an oxidant, the first precursor adsorbed on the catalyst surface may be deposited as an inorganic oxide film, and then, the second precursor may be deposited as an inorganic oxide film, thus forming a layer film by layer-by-layer method.

The oxide may be, for example, alumina (Al₂O₃), titania (TiO₂), zirconia (ZrO₂), zinc oxide (ZnO₂), gallium oxide (GaO₂) and ceria (CeO₂). Preferably, a layer film in which a titania (TiO₂) inorganic film is formed by the first precursor and oxidant, and then, an alumina (Al₂O₃) inorganic film is formed by the second precursor and oxidant, may be provided.

According to one embodiment of the invention, the purge of the steps (a) to (d) is progressed by injecting inert gas. Purge means purification or removal. For example, by injecting inert gas, internal pressure of 0.001 to 1 torr may be provided. If the pressure is less than 0.001 torr, it may be difficult to expect the effect from purge, and if the pressure is greater than 1 torr, it may mean that a reaction precursor or purge gas remains, and thus, by adjusting the pressure of gas used, additional adsorption of reactants may be prevented. The inert gas may be, for example, nitrogen, helium, neon, argon, and the like, but is not limited thereto.

Meanwhile, according to one embodiment of the invention, there is provided a metal catalyst deposited with a layer film by ALD process, prepared according to the preparation method. The same as the above-explained preparation method of a metal catalyst applies thereto, and explanation in overlapping range will be omitted.

According to one embodiment of the invention, the layer film may be deposited with the thickness of 0.1 nm to 2 nm. As explained above, the thickness deposited by progressing the steps (a) to (d) one time may be 0.02 to 0.1 nm. Thus, by repeating these steps two times (dyad) or more as necessary, the thickness of the layer film may be appropriately modified freely at the level of a person having ordinary skill in the art.

According to one embodiment of the invention, the metal catalyst may be in the form of powders, particles, granules and pellets, and preferably, it may be provided in the form of powders or particles.

According to one embodiment of the invention, the metal catalyst may be applied for carbon monoxide oxidation. Particularly, it can provide high catalyst activity and sintering prevention effect in the carbon monoxide oxidation reaction progressed at high temperature of 100°C to 300°C.

Hereinafter, the constructions and actions of the invention will be explained in more detail through preferable examples. However, these are presented as preferable illustrations of the invention, and it should not be interpreted as limiting the invention in any sense. The contents not stated herein may be sufficiently technically inferred by a person having ordinary skill in the art, and the explanations will be omitted.

### Example 1

A gamma-alumina (y-Al₂O₃) supported platinum (Pt) catalyst was put on a substrate of 150°C. As the first precursor, titanium tetraisopropoxide (TTIP) (99.999%, EG Chem, Co. Ltd.) was injected using nitrogen gas as carrier gas for 15 seconds at 150°C, 1 torr and deposited on the catalyst surface, followed by purge under conditions of 150°C, 1 torr for 600 seconds. Thereafter, ultrapure purified water was injected as an oxidant at 150°C, 1 torr for 15 seconds, followed by purge under conditions of 150°C, 1 torr for 600 seconds, thus depositing a TiO₂ inorganic film on the surface of the supported catalyst (steps (a) to (b)). This process was further repeated twice to coat a TiO₂ inorganic film.

Thereafter, as the second precursor, trimethylaluminum (TMA) was injected using nitrogen gas as carrier gas at 150°C, 1 torr for 15 seconds and deposited on the catalyst surface, followed by maintenance at 150°C, 3 torr for 600 seconds in a closed batch. After the maintenance, purge was conducted under conditions of 150°C, 1 torr for 600 seconds. Thereafter, ultrapure purified water was injected as an oxidant at 150°C, 1 torr for 15 seconds, followed by maintenance at 150°C, 3 torr for 600 seconds. After the maintenance, purge was conducted under conditions of 150°C, 1 torr for 600 seconds to deposit an Al₂O₃ inorganic film on the surface of the supported catalyst, thereby coating a layer film (steps (c) to (d)).

The process of (a) to (d) was defined as 1 dyad. 2 dyads were additionally progressed to prepare a platinum catalyst (TiO₂ 3 cycle-Al₂O₃ 1 cycle-coated Pt/γ-Al₂O₃).

### Example 2

The steps (a) to (b) were progressed 10 cycles, and the steps (c) to (d) were progressed 3 cycles. A platinum catalyst was prepared by the same procedure as Example 1, except that the process of (a) to (d) was progressed 1 dyad to prepare a platinum catalyst (TiO₂ 10 cycle-Al₂O₃ 3 cycle-coated Pt/y-Al₂O₃).

### Comparative Example 1

A platinum catalyst supported on an alumina carrier (Bare Pt/ y-Al₂O₃) was prepared without progressing an ALD process.

### Comparative Example 2

A gamma-alumina (y-Al₂O₃) supported platinum (Pt) catalyst was put on a substrate of 150°C. Titanium tetraisopropoxide (TTIP) (99.999%, EG Chem, Co. Ltd.) as the first precursor and trimethylalinimum (TMA) as the second precursor were simultaneously supplied. Nitrogen gas was injected therein as carrier gas at 150°C, 1 torr for 15 seconds and deposited on the catalyst surface, followed by purge under conditions of 150°C, 1 torr for 600 seconds. Thereafter, ultrapure purified water was injected as an oxidant at 150°C, 1 torr for 15 seconds, followed by purge under conditions of 150°C, 1 torr for 600 seconds, thus depositing a layer film on the surface of the supported catalyst. It was progressed 150 cycles (co-injection).

### Experimental Example 1: X-ray photoelectron spectroscopy analysis of catalyst

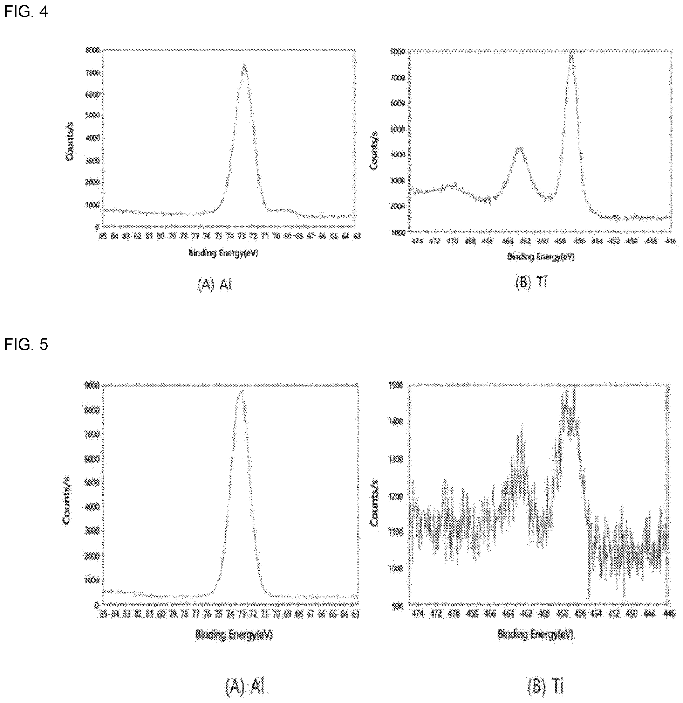

In order to confirm quantity of each element of the catalyst according to Examples 1 to 2 and Comparative Example, photoelectrons projecting during X-ray incidence were analyzed to progress X-ray photoelectron spectroscopy analysis capable of analyzing the kind of elements in a sample, chemical state, and the like, and the results were respectively shown in Fig. 3 and Fig. 4. The catalyst according to Comparative Example 2 was analyzed by the same method, and the results were shown in Fig. 5.

### Experimental Example 2: Evaluation of catalyst activity

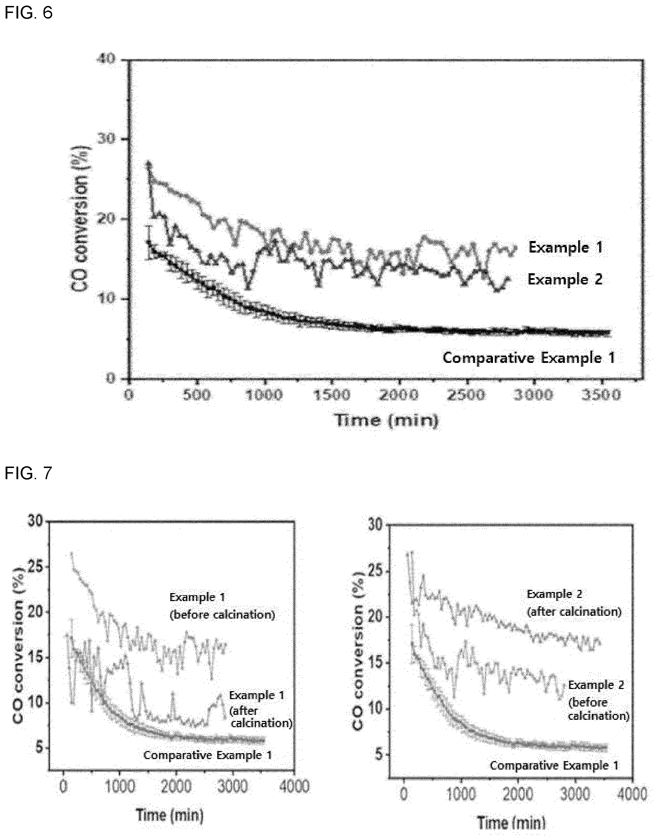

In order to confirm the activities of the catalysts according to Examples 1 to 2 and Comparative Example, CO oxidation was progressed at 150°C, and CO conversion(%) over time was respectively measured and compared. As reaction gas, 5% CO (background gas air) was flowed to a reactor in an amount of 40 ml/min. Further, before the reaction, reduction was progressed at 500°C for 3 hours using 3.9 H₂ (background gas N₂), and then, a CO oxidation reaction was progressed. The results were shown in Fig. 6.

### Experimental Example 3: Evaluation of heat stability of catalyst

In order to confirm heat stabilities of the catalysts according to Examples 1 to 2 and Comparative Example, activity change before and after calcination was confirmed. The calcination process was progressed at 500°C for 2 hours under air conditions. In order to evaluate activity under calcination process condition, CO oxidation was progressed at 150°C, and CO conversion(%) before and after calcination was respectively measured and compared. As reaction gas, 5% CO (background gas air) was flowed to a reactor in an amount of 40 ml/min. Further, before the reaction, reduction was progressed at 500°C for 3 hours using 3.9 H₂ (background gas N₂), and then, a CO oxidation reaction was progressed. The results were shown in Fig. 7.

Fig. 3 to Fig. 5 show the analysis results of X-ray photoelectron spectroscopy, wherein (A) denotes Al analysis result, and (B) denotes Ti analysis result.

Fig. 3 shows the result of Example 1, wherein the At% analysis result was measured to be O1s 49.2%, Al2p 32.99%, Cls 15.51%, Ti2p 2.2%, Pt4d 0.1%.

Fig. 4 shows the result of Example 2, wherein the At% analysis result was measured to be O1s 50.31%, Al2p 30.56%, Ti2p 2.7%, Cls 16.43%.

Fig. 5 shows the result of Comparative Example 2, wherein the At% analysis result was measured to be O1s 56.54%, Al2p 42.8%, Ti2p 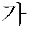 0.19%, Cls 0.47%.

That is, it can be confirmed from the At% analysis result that in the case of Comparative Example 2, Al value was rather higher and Ti value was lower, compared to the values of Examples. It means that since a TiO₂ precursor (TTIP) has lower adsorption degree and lower reactivity compared to a Al₂O₃ precursor (TMA), in case two reactants are simultaneously injected, a Al₂O₃ mono film is mainly formed instead of a layer film. Thus, it can be confirmed through the analysis of Experimental Example 1 that in the case of the present disclosure, layer-by-layer composite film is successfully formed.

Further, examining the result of Fig. 6 according to the present disclosure, it is confirmed that in the case of Examples 1 to 2, activities are remarkably improved compared to Comparative Examples.

Finally, examining the result of Fig. 7 according to the present disclosure, it can be confirmed that in the case of Examples 1 to 2, high activity of the catalyst is maintained under calcination conditions of 500°C, 2 hours, and noticeable sintering prevention effect is exhibited. Meanwhile, it can be confirmed that in the case of Comparative Example 1, catalyst activity is remarkably decreased after calcination progressed at high temperature for long time.

Thus, the layer film by ALD process according to the present disclosure can be successfully prepared by layer-by-layer deposition on the catalyst surface, thereby inhibiting sintering of catalyst particles to prevent activity decrease and stably maintain high activity. Further, high activity and heat stability of a catalyst can be simultaneously provided.

Although the present disclosure has been described by specific matters such as specific constructional elements, and the like, and limited embodiments in the foregoing, they are presented only to assist in more general understanding of the invention, but the invention is not limited to the embodiments, and various modifications and alterations can be made from such descriptions by a person having ordinary knowledge in the technical field to which the invention pertains.

Thus, the idea of the invention should not be determined only by the above-explained embodiments, and the claims described below and all the equal or equivalent modifications to the claims belong to the categories of the idea of the invention.

According to the present disclosure, compared to the existing co-injection preparation method wherein two reactants are simultaneously injected to prepare a layer film, a layer film can be more successfully formed by a layer-by-layer preparation method.

According to the present disclosure, sintering of catalyst particles can be inhibited to prevent activity decrease, and high activity can be stably maintained.

According to the present disclosure, high activity and heat stability of a catalyst can be simultaneously provided.

## Claims

1. A method for preparing a metal catalyst deposited with a layer film by ALD process, comprising steps of:
(a) injecting a first precursor in a supported catalyst to deposit on the catalyst surface, and then, purging;
(b) injecting an oxidant to react with the first precursor deposited on the catalyst surface to form an inorganic film, and then, purging;
(c) injecting a second precursor to deposit the second precursor on the inorganic film, and then, purging; and
(d) injecting an oxidant to form a layer film, and then, purging.

2. The method for preparing a metal catalyst deposited with a layer film by ALD process according to claim 1, wherein the steps (a) to (b) are repeated 3 to 10 cycles, and then, the steps (c) to (d) are repeated 1 to 3 cycles.

3. The method for preparing a metal catalyst deposited with a layer film by ALD process according to claim 1, wherein the steps (a) to (d) are repeated at least two times (dyad).

4. The method for preparing a metal catalyst deposited with a layer film by ALD process according to claim 1, wherein the catalyst of the step (a) is one selected from platinum (Pt), gold (Au), silver (Ag), copper (Cu), nickel (Ni), palladium (Pd), rhodium (Rh) and ruthenium (Ru).

5. The method for preparing a metal catalyst deposited with a layer film by ALD process according to claim 1, wherein the supporting of the step (a) uses at least one selected from alumina, silica, zeolite, titanium, zirconia and carbon as a carrier.

6. The method for preparing a metal catalyst deposited with a layer film by ALD process according to claim 1, wherein the first precursor of the step (a) and the second precursor of the step (c) are different from each other.

7. The method for preparing a metal catalyst deposited with a layer film by ALD process according to claim 1, wherein each of the first precursor of the step (a) and the second precursor of the step (c) is at least one selected from titanium (Ti), aluminum (Al), zinc (Zn), zirconium (Zr) and cesium (Ce).

8. The method for preparing a metal catalyst deposited with a layer film by ALD process according to claim 1, wherein the injections of the steps (a) and (c) are respectively progressed by injecting inert gas as carrier gas.

9. The method for preparing a metal catalyst deposited with a layer film by ALD process according to claim 1, wherein each oxidant of the step (b) and step (d) is at least one selected from ultrapure purified water, alcohol, ozone, nitrous oxide and oxygen.

10. The method for preparing a metal catalyst deposited with a layer film by ALD process according to claim 1, wherein the purging of the steps (a) to (d) is progressed by injecting inert gas.

11. The method for preparing a metal catalyst deposited with a layer film by ALD process according to claim 1, wherein the purging of the steps (a) to (d) is progressed under pressure of 0.001 to 1 torr.

12. A metal catalyst deposited with a layer film by ALD process, prepared according to any one of claims 1 to 11.

13. The metal catalyst deposited with a layer film by ALD process according to claim 12, wherein the layer film has a thickness of 0.1 nm to 2 nm.

14. The metal catalyst deposited with a layer film by ALD process according to claim 12, wherein the metal catalyst is provided in the form of at least one selected from powders, particles, granules and pellets.

15. The metal catalyst deposited with a layer film by ALD process according to claim 12, wherein the metal catalyst is used for carbon monoxide oxidation.
